**Europäisches Patentamt**

**European Patent Office**

**Office européen des brevets**

(19)

(11) Publication number : **0 281 590 B1**

# (12) EUROPEAN PATENT SPECIFICATION

(45) Date of publication of patent specification :
08.07.92 Bulletin 92/28

(51) Int. Cl.⁵ : **H01L 27/02**

(21) Application number : **87905678.6**

(22) Date of filing : **20.07.87**

(86) International application number :
**PCT/US87/01707**

(87) International publication number :
**WO 88/02185 24.03.88 Gazette 88/07**

(54) INTEGRATED CIRCUIT MASTERSLICE.

(30) Priority : **08.09.86 US 904998**

(43) Date of publication of application :
**14.09.88 Bulletin 88/37**

(45) Publication of the grant of the patent :
**08.07.92 Bulletin 92/28**

(84) Designated Contracting States :
**CH DE FR GB IT LI NL**

(56) References cited :
**US-A- 4 513 307**

(56) References cited :
IEEE Journal of Solid-State Circuits, volume SC-19, no. 5, October 1984, IEEE, (New York, US), S Tanaka et al.: "Asubnanosecond 8K-gate CMOS/SOS gate array", pages 657-663 see figures 4-6; pages 659-660, paragraph 111: "Fabrication and design of8K-gate CMOS/SOS gate array
IEEE Transactions on Electron Devices, volume ED-29, no. 10, October 1982, IEEE, (New York, US), N Sasaki et al.: "A CMOS/SOSgate array with a new customization technique of cutting", pages 1535-1541 see figures 1-5; pages 1536-1537, paragraph 11: "A newcustomization technique"

(73) Proprietor : **Hughes Aircraft Company**
**7200 Hughes Terrace P.O. Box 45066**
**Los Angeles, California 90045-0066 (US)**

(72) Inventor : **HENDERSON, Richard, C.**
**1121 Stoneshead Court**
**Westlake Village, CA 91361 (US)**

(74) Representative : **KUHNEN, WACKER & PARTNER**
**Alois-Steinecker-Strasse 22 Postfach 1553**
**W-8050 Freising (DE)**

EP 0 281 590 B1

## Description

## BACKGROUND OF THE INVENTION

### Field of the Invention

This invention relates to wafers for integrated circuits which are processed to a standard, partially complete pattern and can thereafter be completed with customized circuitry.

### Description of the Prior Art

Semiconductive wafers for integrated circuits have traditionally been provided as a blank wafer of material which serves as a substrate for the desired circuitry. To reduce individualized process steps, gate array wafers have been introduced. These wafers are processed to a nearly complete state with a standard pattern, at which point they are stored ready for completion with a custom interconnect layer. In this way only a relatively short period of time is required to fabricate and test an integrated circuit once the design has been completed. A reference on this technology is provided in a text edited by John W. Read, "Gate Arrays: Design Techniques and Applications", McGraw-Hill (1985).

One of the drawbacks of gate arrays as compared with a totally customized geometry is that they employ predefined channels for wire and predefined areas for transistor gates, an approach that is quite wasteful of space on the wafer ("real estate"). Also, the predefinition of the transistor gates normally precludes the inclusion of on-chip ROM or RAM.

## SUMMARY OF THE INVENTION

In view of the above problems associated with the prior art, it is an object of this invention to provide an integrated circuit "masterslice", or standardized wafer, that incorporates an integral sea of transistors and yet accommodates a dense interconnect wiring grid connected to an underlying dense transistor grid.

Another object is the provision of such an integrated circuit masterslice which is very flexible in the types of circuits it will accept, allows the placement of wires, gates or cells virtually anywhere on the wafer surface, and can easily accommodate both RAM and ROM cells.

A further object is the provision of such an integrated circuit masterslice which has a circuit design flexibility similar to that of customized integrated circuits, and yet like gate arrays requires only one to three custom metallization levels to obtain a finished integrated circuit, and which further permits any transistor on the wafer to be connected or not connected to the wiring, as desired.

These and other objects of the invention are realized with an integrated circuit masterslice which is formed on an insulative substrate, and has a plurality of mutually spaced active device columns disposed along the substrate. Each column incorporates successive pairs of n-channel field effect transistors (FETs) alternating with successive pairs of p-channel FETs, with each FET including gate, source and drain contacts that are accessible by a surface metallization. The FETs of each column share their drain and source contacts with the adjacent FETs on the same column, such that the number of drain/source contacts is substantially no greater than the number of FETs per column; this results in a substantial savings in real estate. Corresponding FET contacts of the various columns are positioned in rows extending across the columns, and some of the drain/source contacts may be omitted to provide additional space for cross-column surface metallizations. The FET contacts in adjacent columns are arranged to provide for gate isolation by surface metallization between adjacent columns.

In a particular embodiment, each of the columns comprises a respective layer of semiconductive material over the substrate, with spaced conductive source and drain contacts on the semiconductive layer. An insulative layer extends between the source and drain contacts, with polycrystalline semiconductive gates formed in the insulative layer between successive source and drain contacts and separated from the semiconductive layer by a portion of the insulative layer. Gate contacts are formed over the gates; all of the FET contacts are forced from a semiconductor/metal alloy. The semiconductive layer below and between the source and drain contacts and the gate of each FET is doped in accordance with the polarity of the respective n-channel and p-channel devices.

The invention offers the potential of achieving an extremely high degree of circuit integration. For example, with a half $\mu$m (micron) wide gate geometry, an array area of 8 mm. x 8.3 mm. will accommodate 3 million transistors. Thus, the invention could be applicable to many different existing products involving integrated circuits.

These and other objects and features of the invention will be apparent to those skilled in the art from the following detailed description of preferred embodiments, taken together with the accompanying drawings, in which:

## DESCRIPTION OF THE DRAWINGS

FIG. 1 is a plan view of a portion of an integrated circuit masterslice formed in accordance with the invention;

FIGs. 2-6 are sectional views taken along the lines 2-2 through 6-6 of FIG. 1, respectively, showing various portions of the masterslice construction;

FIG. 7 is a plan view of a portion of the masterslice similar to FIG. 1, showing possible metallization menus;

FIG. 8a is a plan view of a portion of the masterslice illustrating a metallization layout to obtain a NAND gate;

FIG. 8b is a schematic diagram of the circuit resulting from the layout of FIG. 8a; and

FIG. 9 is a plan view of a portion of the masterslice showing a metallization layout that will provide a ROM cell.

## DETAILED DESCRIPTION OF PREFERRED EMBODIMENTS

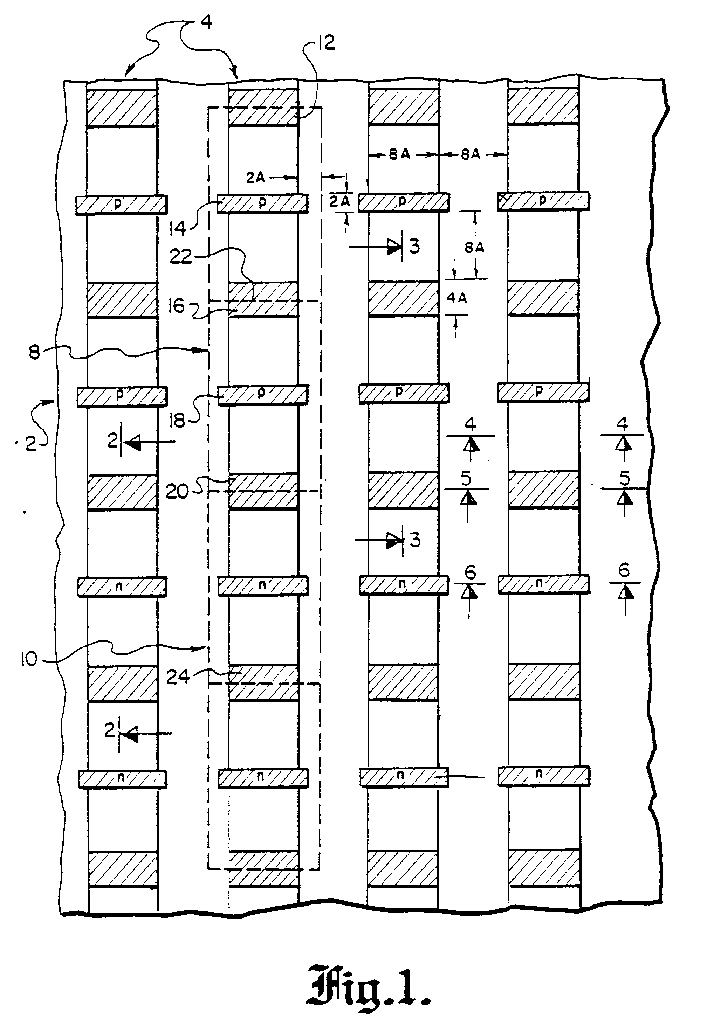

Referring first to FIG. 1, a portion of an integrated circuit masterslice 2 is shown in which a plurality of parallel columns comprising semiconductive is lands 4 are formed on an insulative substrate 6. Only a small portion of the masterslice is shown, but a similar pattern is replicated throughout the array area. The columns might actually extend for about 500 times the length illustrated, and the total number of columns might be in the order of about 2,000. Illustrative dimensions for the various devices formed on the masterslice are given in terms of a normalized distance unit A, which typically would be on the order of about 0.25 or 0.5 μm (microns).

Each of the columns has a standard pattern that is replicated throughout its length. This pattern is indicated by the dashed lines in the second column from the left. A series of two p-channel FETs are included within the upper heavy-dashed lined rectangle 8; a series of two n-channel FETs are included within the lower heavy-dashed lined rectangle 10. Referring to the p-channel rectangle 8, the FET contacts comprise, beginning from the top, a source / drain contact 12, gate contact 14, source / drain contact 16, gate contact 18, and source/drain contact 20. The division between the two FETs is indicated by a light-dashed line 22 bisecting source/drain contact 16. The contacts for the upper FET consist of source/drain contact 12, gate contact 14, and source/drain contact 16; the contacts for the lower p-channel FET consist of source/ drain contact 16 (in common with the upper FET), gate contact 18, and contact 20. Thus, the two p-channel devices share the single source/drain contact 16, which provides a source contact for one device and a drain contact for the other. All of the contacts are exposed and accessible to receive surface metallization to implement a circuit interconnection.

The construction of the n-channel section 10 is similar to that of p-channel 8, with the polarity of the channel doping reversed. The upper n-channel FET shares source/drain contact 20 with the lower p-channel FET, while the intermediate source/drain channel 24 is shared by the two n-channel devices. Likewise, the lower n-channel FET shares its lower source/drain contact 26 with a p-channel device (not shown) immediately below.

Thus, each FET shares its drain and source contacts with the adjacent FETs of the same column. It can also be seen that the various columns are formed in a similar manner to each other with the gate and source/drain contacts of one column aligned in rows with the corresponding contacts of the other columns. If desired, some of the drain/ source contacts may be omitted to provide additional space for cross-column surface metallizations, thereby increasing the flexibility of the masterslice for some applications.

The masterslice is formed using CMOS technology, with the long columns 4 comprising epitaxial islands which are physically separated, and thereby electrically isolated, from each other. A cross-section taken along one of the columns to illustrate the construction of an n-channel FET and its interface with an adjacent p-channel device is illustrated in FIG. 2. The substrate 6 is an insulator such as sapphire. A single crystal hetero-epitaxy semiconductive layer 26 is grown on the insulator. Various semiconductive materials such as silicon, germanium or gallium arsenide may be used. A layer of insulative material 28 is formed on top of semiconductive layer 26 from silicon dioxide, silicon nitride or other suitable insulator. The thicknesses of layers 26 and 28- each typically range from about 0.2 to 0.6 μm (microns).

The two source/drain contacts 20, 24 are recessed into the insulative layer 28 to contact the underlying semiconductor layer 26. The source/drain contacts are formed from a semiconductor/metal alloy, such as a silicide, which is metallized so that a metal layer deposited upon the surface of the masterslice establishes a firm mechanical and electrical connection to the contacts. The contacts are typically about 0.1 μm (microns) thick.

A gate assembly 30 is formed in the insulative layer 28 between the two source/drain contacts 20, 24. The gate assembly consists of a body of polycrystalline semiconductive material 32 such as phosphorous doped polysilicon, capped by a thin semiconductor/metal alloy contact 34 similar to the source/drain contacts. The gate assembly preferably is formed by a surface planar process in which the polysilicon is first surrounded by an insulative oxide, with the top portion of the oxide then selectively removed to expose the polysilicon, followed by silicizing the upper portion of the polysilicon. This produces a structure in which the insulative layer abuts directly against the gate structure to prevent a later surface metallization from flowing down between the gate and insulative material.

The gate 32 does not extend all the way down to the epitaxial island 26, but rather is separated therefrom by a thin layer of the insulative material 28, typically on the order of about 0.01-0.02 μm (microns)

thick, and provides the usual insulated gate function.

The epitaxial layer 26 is doped to implement the desired device. For an n-channel FET, the epitaxy is doped n+ except immediately underneath the gate, where it is p-. Beginning from the middle of source/drain contact 20 and extending to the right, the epitaxy is doped p+, indicating the beginning of a p-channel device. This further illustrates the dual role of contact 20 in serving as a source or drain contact for both adjacent n-channel and p-channel devices.

FIG. 3 is a cross-section of a p-channel device, also showing its interface with an n-channel device under a source/drain contact 20. Its construction is essentially similar to the n-channel device illustrated in FIG. 2, with the doping polarity of the epitaxial layer 26 reversed. The source/drain contact 16 and gate contact 18 correspond to those identified in FIG. 1.

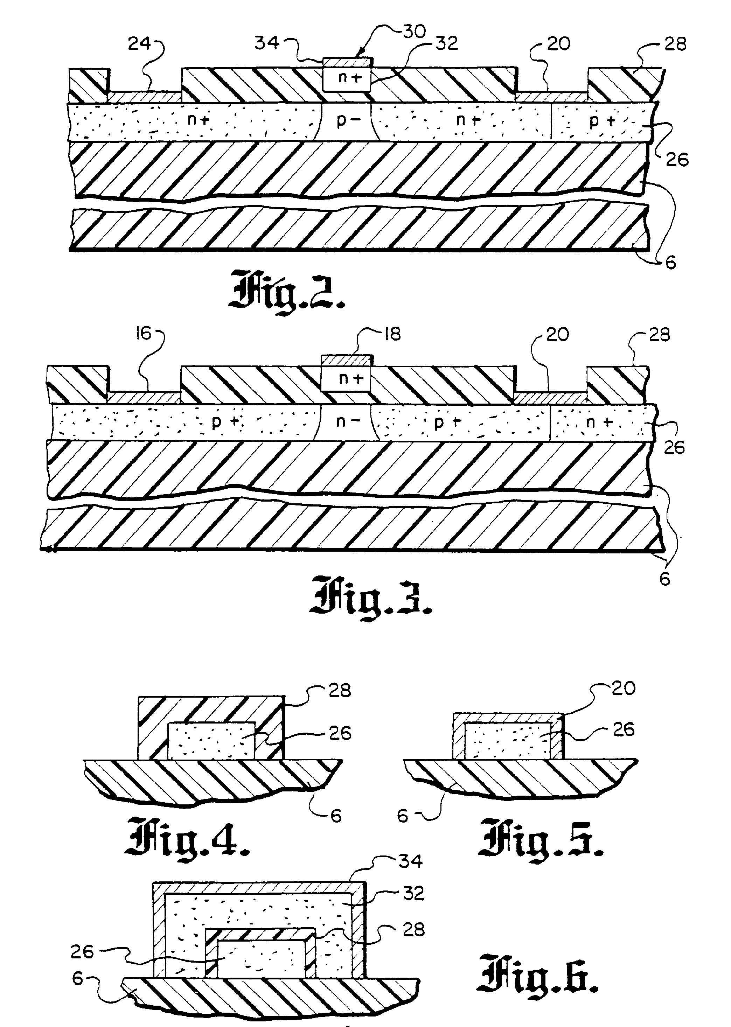

Cross-sections of the columns at a location between contacts, at a source/drain contact and at a grate are illustrated in FIGs. 4, 5 and 6, respectively. It should be noted that in each case there is a gap between adjacent columns, which are joined only by the insulative substrate 6. This electrically isolates the columns from each other.

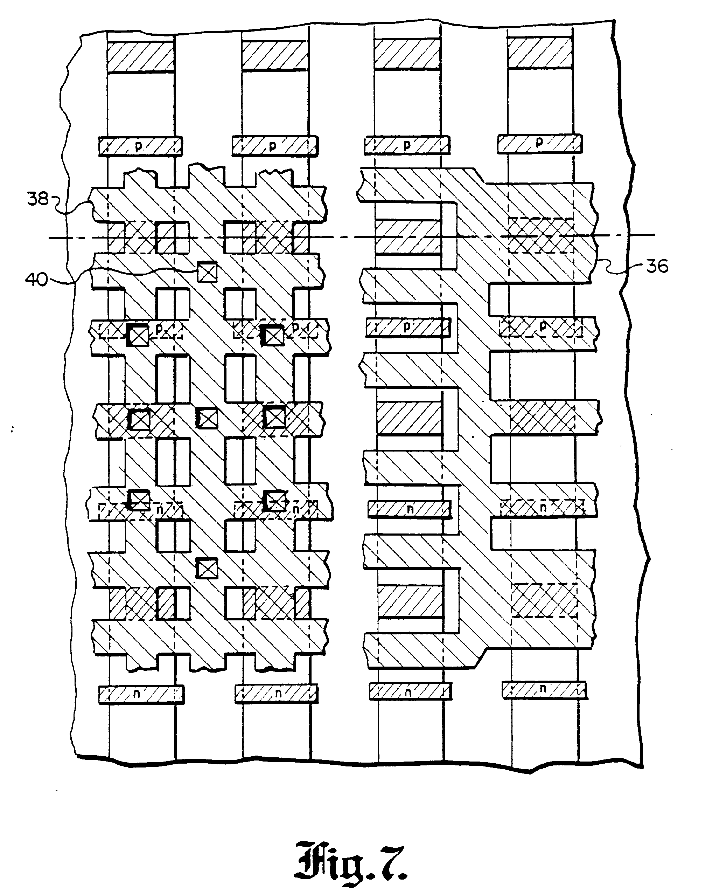

FIG. 7 is an illustration of a menu of permissible metallization patterns that may be flowed over the masterslice to interconnect its various elements. The metallization 36 for the two right hand columns illustrates the crossing of a column with or without connections to the column contacts, and the extension of metallization up and down a column. The metallization menu 38 for the two left hand columns has the appearance of a mesh formed by two metallization layers which are separated by an insulative oxide layer. Connections from the upper metallization layer to the underlying masterslice are implemented by metallized openings or "vias" 40 through the intervening insulative layer.

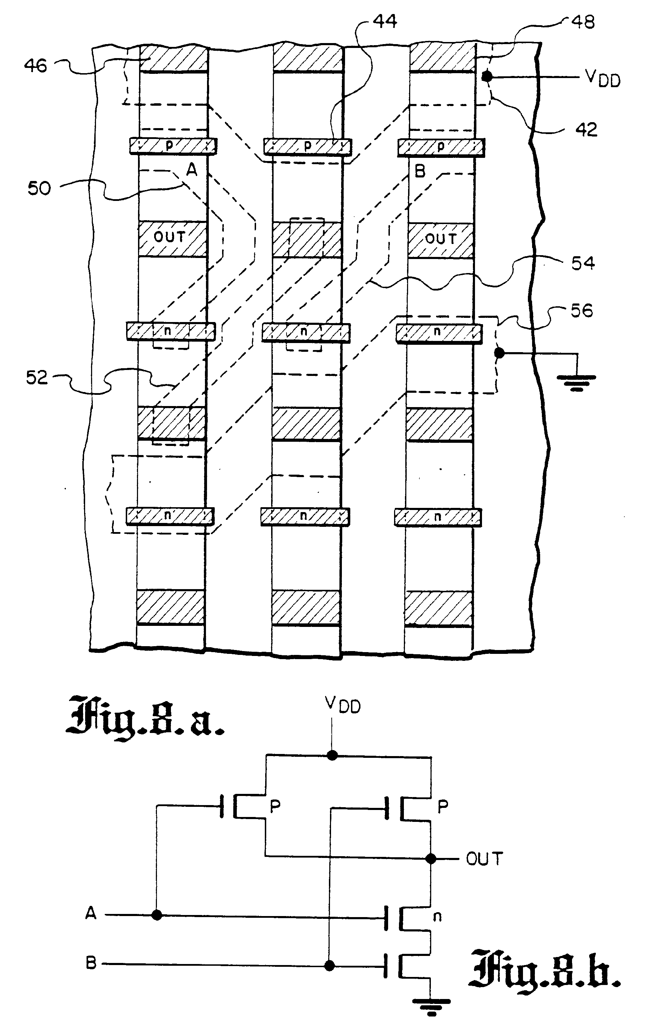

FIGs. 8a and 8b illustrate the formation of a 2 input NAND gate on the masterslice, and its corresponding schematic diagram, respectively. A metallization 42 interconnects the upper p-channel gate 44 of the middle column with the upper source/drain contacts 46, 48 of the left and right columns to a positive voltage $V_{DD}$. This constant positive voltage to the p-channel gate (typically +5 volts) holds its associated FET off, thereby providing gate isolation between the p-channel and the n-channel device immediately below it on the column. At the same time, $V_{DD}$ provides a fixed voltage reference for the sources of the p-channel devices associated with source/ drain contacts 46 and 48.

The NAND gate is formed by the indicated metallizations 50, 52 and 54 in the three columns immediately below metallization 42. Gate isolation for the left and right columns immediately below the device, and a fixed ground reference for the drain of the middle column FET, are provided by a grounded metallization 56. This connects the n-channel gates of the left and right columns immediately below the NAND gate with the intervening source/drain contact of the middle column. Grounding the n-channel gates holds their respective FETs off to provide the desired gate isolation.

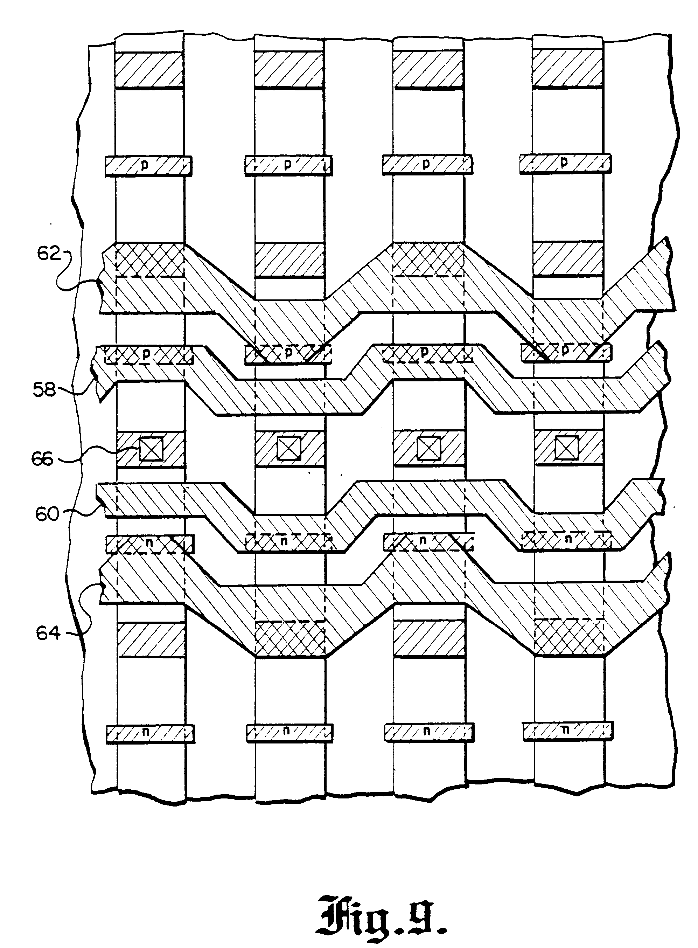

The application of the invention to a ROM cell is illustrated in FIG. 9. A "low" wire metallization 58 extends across the columns to connect every other p-channel gate in a row, while a "high" wire metallization 60 extends across the same columns to connect every other n-channel gate of the intervening columns. A $V_{DD}$ metallization 62 applies voltage to the source/drain contact immediately above each "low" p-channel gate contact, and to the p-channel gate contacts in-between the "low" contacts. A grounded metallization 64 places ground potential on the source/drain contacts immediately below each of the "high" n-channel gate contacts, and on the n-channel gate contacts between the "high" contacts. The cell operates by pulsing the n-channel and p-channel row select lines. A 1 ($V_{DD}$) or a zero (ground) will appear on the central node 66 between the "low" and "high" lines, depending upon the signals applied to the columns by column select circuitry (not shown). While a compact ROM cell is shown, a RAM cell could also be conveniently laid out on the masterslice. RAM and ROM cells can be readily implemented on the same "floor plan".

Another advantage of the masterslice is that additional real estate is not required for the metallization "vias", other than the area occupied by the vias themselves. In some prior art a large area land must be provided for each via. This is not necessary for the present invention, due to the use of silicided contacts and the abutment of the insulative layer directly against the gate, which prevents the metal from flowing down the side of the gate.

## Claims

1. An integrated circuit masterslice, comprising:
   an insulative substrate, and
   a plurality of mutually spaced active device columns formed on the substrate, each column having formed therein successive pairs of n-channel field effect transistors (FETs) alternating with successive pairs of p-channel FETs, the FETs including gate, source and drain contacts that are accessible by a surface metallization.

2. The integrated circuit masterslice of claim 1, wherein the FETs of each column share their drain and source contacts with the adjacent FETs of the same column.

3. The integrated circuit masterslice of claim 2, wherein some of the drain/source contacts are omitted to provide additional space for cross-column surface metallizations.

4. The integrated circuit masterslice of claim 2, wherein the number of drain/source contacts is substantially no greater than the number of FETs per column.

5. The integrated circuit masterslice of claim 1, wherein the FET contacts in adjacent columns are arranged to provide for gate isolation by surface metallization between adjacent columns.

6. The integrated circuit masterslice of claim 1, wherein corresponding FET contacts of the various columns are positioned in rows extending across the columns.

7. The integrated circuit masterslice of claim 1, wherein the columns comprise respective layers of semiconductive material over the substrate, spaced conductive source and drain contacts on the semiconductive layer, an insulative layer between the source and drain contacts, polycrystalline semiconductive gates formed in the insulative layer between successive source and drain contacts and separated from the semiconductive layer by a portion of the insulative layer, and gate contacts over the gates, the semiconductive layer below and between the source and drain contacts and the gate for each FET being doped in accordance with the polarity of the respective FETs.

8. The integrated circuit masterslice of claim 7, wherein the FET contacts are formed from a semiconductor/metal alloy.

9. The integrated circuit masterslice of claim 7, wherein the insulative layer directly abuts against the gate to prevent a surface metallization from flowing down between the gate and insulative area.

10. An integrated circuit masterslice, comprising:
an insulative substrate,
a plurality of semiconductive islands formed on the substrate in parallel columns and electrically isolated from each other by the substrate, the islands having alternating p and n doped sections along their lengths,
respective source/drain contacts formed from a metal/semiconductor alloy overlying and straddling the islands' p-n junctions, and overlying the islands between each successive pair of p-n junctions,
an insulative layer overlying each island between said source/drain contacts,
respective polycrystalline semiconductive gates in the insulative layer between each successive pair of source/drain contacts and spaced from the underlying island by a thin section of the insulative material, and
respective metal/semiconductor alloy contacts on the gates,
the portions of the islands immediately underlying the gates being doped to a polarity opposite that of the adjacent island material, whereby successive pairs of p-channel field effect transistors (FETs) are formed along the islands in alternation with successive pairs of n-channel FETs, with the island contacts providing common source/drain contacts for adjacent FETs.

11. The integrated circuit masterslice of claim 10, wherein the islands are arranged in columns and are substantially similar to each other, with corresponding elements of the various islands arrange in rows.

12. the integrated circuit masterslice of claim 10, wherein the FETs are arranged on their respective islands to provide for a surface metallization between a gate contact on one island and source/drain contacts on adjacent islands, whereby a voltage signal may be applied to the metallization to provide gate isolation for the one island and a voltage reference for the adjacent islands.

## Patentansprüche

1. Integrierte Masterslice-Schaltung, welche aufweist:
ein isolierendes Substrat, und
eine Vielzahl von gegeneinander räumlich versetzter aktiver Vorrichtungsspalten, welche auf dem Substrat gebildet sind, wobei jede Spalte hierin ausgebildet aufweist aufeinanderfolgende Paare von n-Kanal-Feldeffekttransistoren (FETs), welche abwechselnd mit aufeinanderfolgenden Paaren von p-Kanal-FETs angeordnet sind, wobei die FETs Gate-Source- und Drain-Kontakte aufweisen, auf die durch eine Oberflächenmetallisierung zugreifbar ist.

2. Integrierte Masterslice-Schaltung nach Anspruch 1, dadurch gekennzeichnet, daß die FETs von jeder Spalte ihre Drain- und Source-Kontakte mit den benachbarten FETs derselben Spalte teilen.

3. Intergrierte Masterslice-Schaltung nach Anspruch 2, dadurch gekennzeichnet, daß einige der Drain/Source- Kontakte weggelassen sind, um zusätzlichen Raum für spaltenkreuzende Oberflächenmetallisierungen zur Verfügung zu stellen.

4. Integrierte Masterslice-Schaltung nach Anspruch 2, dadurch gekennzeichnet, daß die Anzahl der Drain/Source-Kontakte im wesentlichen nicht größer ist als die Anzahl der FETs pro Spalte.

5. Integrierte Masterslice-Schaltung nach Anspruch 1, dadurch gekennzeichnet, daß die FET-Kontakte in benachbarten Spalten derart angeordnet sind, daß durch die Oberflächenmetallisierung zwischen benachbarten Spalten eine Gate-Isolation zur Verfügung gestellt wird.

6. Intergrierte Masterslice-Schaltung nach Anspruch 1, dadurch gekennzeichnet, daß entsprechende FET-Kontakte der verschiedenen Spalten in Zeilen angeordnet sind, die sich über die Spalten erstrecken.

7. Integrierte Masterslice-Schaltung nach Anspruch 1, dadurch gekennzeichnet, daß die Spalten jeweils Schichten aus halbleitendem Material über das Substrat, beabstandete leitende Source- und Drain- Kontakte auf der Halbleiterschicht, eine Isolationschicht zwischen den Source- und Drain- Kontakten, polykristalline halbleitende Gates, welche in der Isolationsschicht zwischen aufeinanderfolgenden Source- und Drain- Kontakten gebildet sind und von der halbleitenden Schicht durch einen beschnitt der Isolationsschicht getrennt sind, und Gate-Kontakte oberhalb der Gates aufweisen, wobei die halbleitende Schicht unterhalb und zwischen den Source- und Drain- Kontakten und das Gate für jeden FET entsprechend der Polaritäten der jeweiligen FETs dotiert ist.

8. Integrierte Masterslice-Schaltung nach Anspruch 7, dadurch gekennzeichnet, daß die FET-Kontakte aus einer Halbleiter/Metallegierung gebildet sind.

9. Integrierte Masterslice-Schaltung nach Anspruch 7, dadurch gekennzeichnet, daß die Isolationsschicht direkt gegen das Gate angrenzt, um ein Herabfließen einer Oberflächenmetallisierung zwischen den Gate- und Isolationsbereich zu verhindern.

10. Integrierte Masterslice-Schaltung, welche aufweist:

ein isolierendes Substrat,

eine Vielzahl von halbleitenden Inseln, welche auf dem Substrat in parallelen Spalten gebildet sind und elektrisch voneinander durch das Substrat isoliert sind, wobei die Inseln entlang deren Längen alternierende p- und n-dotierte Bereiche aufweisen,

jeweils Source/Drain-Kontakte, welche aus einer Metall/Halbleiterlegierung gebildet sind, welche oberhalb der p-n-Übergänge der Inseln zu liegen kommen und diese überfahren, und oberhalb der Inseln zwischen jedem aufeinanderfolgenden Paar von p-n-Übergängen zu liegen kommen,

eine Isolationsschicht, welche oberhalb jeder Insel zwischen den Source/Drain-Kontakten zu liegen kommt,

jeweils polykristalline halbleitende Gates in der Isolationsschicht zwischen jedem aufeinanderfolgenden Paar von Source/Drain-Kontakten und beabstandet von der darunterliegenden Insel durch einen dünnen Bereich des isolierenden Materials, und

jeweils Metall/Halbleiterlegierungskontakte auf den Gates,

wobei die beschnitte der Inseln unmittelbar unterhalb der Gates mit einer Polarität entgegengesetzt zu derjenigen des benachbarten Inselmaterials dotiert sind, wodurch aufeinanderfolgende Paare von p-Kanal-Feldeffekttransistoren (FETs) entlang den Inseln abwechselnd zu aufeinanderfolgenden Paaren von n-Kanal-FETs gebildet sind, wobei die Inselkontakte gemeinsame Source/Drain-Kontakte für benachbarte FETs zur Verfügung stellen.

11. Integrierte Masterslice-Schaltung nach Anspruch 10, dadurch gekennzeichnet, daß die Inseln in Spalten angeordnet sind und im wesentlichen einander ähnlich sind, wobei entsprechende Elemente der verschiedenen Inseln in Zeilen angeordnet sind.

12. Integrierte Masterslice-Schaltung nach Anspruch 10, dadurch gekennzeichnet, daß die FETs auf ihren jeweiligen Inseln derart angeordnet sind, daß eine Oberflächenmetallisierung zwischen einem Gate-Kontakt auf einer Insel und Source/Drain-Kontakte auf benachbarten Inseln zur Verfügung gestellt werden, wodurch ein Spannungssignal an die Metallisierung anlegbar ist zur Ermöglichung einer Gate-Isolation für die eine Insel und einer Spannungsreferenz für die benachbarten Inseln.

**Revendications**

1. Plaquette à gravure banalisée pour circuits intégrés, comprenant:

un substrat isolant; et

un ensemble de colonnes de dispositifs actifs mutuellement espacées formées sur le substrat, chaque colonne ayant, formées sur celle-ci, des paires successives de transistors à effet de champ à canal N alternant avec des paires successives de transistors à effet de champ à canal P, les transistors à effet de champ comportant des contacts de grille, de source et de drain qui sont accessibles par une métallisation en surface.

2. Plaquette à gravure banalisée pour circuits intégrés selon la revendication 1, dans laquelle les transistors à effet de champ de chaque colonne partagent leurs contacts de drain et de source avec les transistors voisins de la même colonne.

3. Plaquette à gravure banalisée pour circuits intégrés selon la revendication 2, dans laquelle certains des contacts drain/source sont omis pour laisser de la place supplémentaire pour des métallisations en surface transversales aux colonnes.

4. Plaquette à gravure banalisée pour circuits intégrés selon la revendication 2, dans laquelle le nombre de contacts drain/source n'est pas sensiblement plus grand que le nombre de transistors à effet de champ par colonne.

5. Plaquette à gravure banalisée pour circuits intégrés selon la revendication 1, dans laquelle les contacts des transistors dans des colonnes voisines sont agencés pour assurer un isolement de grille par métallisation en surface entre les colonnes voisines.

6. Plaquette à gravure banalisée pour circuits intégrés selon la revendication 1, dans laquelle des contacts correspondants des différentes colonnes sont disposés en rangées s'étendant transversalement aux colonnes.

7. Plaquette à gravure banalisée pour circuits intégrés selon la revendication 1, dans laquelle les colonnes comprennent des couches respectives de matière semi-conductrice sur le substrat, des contacts conducteurs de source et de drain espacés sur la couche semi-conductrice, une couche isolante entre les contacts de source et de drain, des grilles semi-conductrices polycristallines formées dans la couche isolante entre des contacts successifs de source et de drain et séparées de la couche semi-conductrice par une partie de la couche isolante, et des contacts de grille au-dessus des grilles, la couche semi-conductrice située sous et entre les contacts de source et de drain et la grille de chaque transistor étant dopée selon la polarité des transistors respectifs.

8. Plaquette à gravure banalisée pour circuits intégrés selon la revendication 7, dans laquelle les contacts des transistors à effet de champ sont formés à partir d'un alliage de semi-conducteur et de métal.

9. Plaquette à gravure banalisée pour circuits intégrés selon la revendication 7, dans laquelle la couche isolante vient buter directement contre la grille pour empêcher une métallisation en surface de passer entre la grille et la zone isolante.

10. Plaquette à gravure banalisée pour circuits intégrés, comprenant:

un substrat isolant;

un ensemble d'îlots semi-conducteurs formés sur le substrat en colonnes parallèles et isolés électriquement les uns des autres par le substrat, les îlots ayant des tronçons dopés P et N en alternance suivant leur longueur;

des contacts source/drain respectifs formés à partir d'un alliage de métal et de semi-conducteur recouvrant et chevauchant les jonctions PN des îlots, et recouvrant les îlots entre chaque paire successive de jonctions PN;

une couche isolante recouvrant chaque îlot entre lesdits contacts source/drain;

des grilles semi-conductrices polycristallines respectives dans la couche isolante entre chaque paire successive de contacts source/drain et espacées de l'îlot sous-jacent par un mince tronçon de matière isolante; et

des contacts respectifs en alliage de métal et de semi-conducteur sur les grilles, les parties des îlots situées immédiatement sous les grilles étant dopées à une polarité opposée à celle de la matière voisine de l'îlot, de sorte que des paires successives de transistors à effet de champ à canal P sont formées le long des îlots, en alternance avec des paires successives de transistors à effet de champ à canal N, les contacts des îlots constituant des contacts communs source/drain pour les transistors à effet de champ voisins.

11. Plaquette à gravure banalisée pour circuits intégrés selon la revendication 10, dans laquelle les îlots sont disposés en colonnes et sont sensiblement semblables entre eux, les éléments correspondants des différents îlots étant disposés en rangées.

12. Plaquette à gravure banalisée pour circuits intégrés selon la revendication 10, dans laquelle les transistors à effet de champ sont disposés sur leurs îlots respectifs en prévision d'une métallisation en surface entre un contact de grille sur un îlot et des contacts source/drain formés sur des îlots voisins, de sorte qu'un signal de tension peut être appliqué à la métallisation pour assurer une isolation de grille pour cet îlot et une référence de tension pour les îlots voisins.

**Fig.1.**

Fig.2.

Fig.3.

Fig.4.

Fig.5.

Fig.6.

**Fig.7.**

**Fig.8.a.**

**Fig.8.b.**

**Fig.9.**